Europäisches Patentamt

European Patent Office

Office européen des brevets

(19)

(11) EP 0 614 587 B1

(12) **EUROPÄISCHE PATENTSCHRIFT**

(45) Veröffentlichungstag und Bekanntmachung des Hinweises auf die Patenterteilung:
**20.05.1998 Patentblatt 1998/21**

(21) Anmeldenummer: 92923760.0

(22) Anmeldetag: **20.11.1992**

(51) Int Cl.6: **H04L 27/14**, H03D 3/18

(86) Internationale Anmeldenummer:
**PCT/EP92/02675**

(87) Internationale Veröffentlichungsnummer:
**WO 93/11623 (10.06.1993 Gazette 1993/14)**

(54) **DEMODULATIONSVERFAHREN MIT ANWENDUNG EINER QUADRATURMODULATION**

DEMODULATION METHOD USING QUADRATURE MODULATION

PROCEDE DE DEMODULATION AVEC APPLICATION D'UNE MODULATION DEPHASEE EN QUADRATURE

(84) Benannte Vertragsstaaten:
**AT BE CH DE ES FR GB IT LI NL SE**

(30) Priorität: **25.11.1991 AT 2348/91**

(43) Veröffentlichungstag der Anmeldung:
**14.09.1994 Patentblatt 1994/37**

(73) Patentinhaber: **Siemens Aktiengesellschaft Österreich
1210 Wien (AT)**

(72) Erfinder:
• **KREUZGRUBER, Peter
A-1080 Wien (AT)**
• **SCHLADOFSKY, Werner
A-1130 Wien (AT)**
• **SCHLAGER, Peter
A-3204 Kirchberg/Piel (AT)**

(74) Vertreter: **Epping, Wilhelm, Dr.-Ing.
Patentanwalt
Postfach 22 13 17
80503 München (DE)**

(56) Entgegenhaltungen:
GB-A- 2 189 114          GB-A- 2 244 410
US-A- 4 608 540          US-A- 4 737 728
US-A- 4 910 467

**Beschreibung**

Die Erfindung betrifft ein Verfahren zur Demodulation von in modulierte Signale umgesetzten Impulstelegrammen unter Anwendung einer Quadraturmodulation gemäß dem Oberbegriff des Patentanspruches 1.

Bei der drahtlosen Übertragung digitalisierter Signale, wie sie beispielsweise bei Schnurlostelefonen üblich ist, wird aus Gründen der leichten Handhabung eine Miniaturisierung der Geräte angestrebt, die bei dem derzeitigen Stand der Technik vorwiegend durch eine vermehrte Anwendung integrierter Schaltungen, d. h. durch Vermeidung analoger Bauteile erzielbar ist.

Aus der GB-A-2 189 114 ist ein Funksignalempfänger bekannt, der zur Demodulation eines FSK-Signals eine Demodulationsanordnung mit Quadraturmodulationsmitteln, Komparator-/Umsetzmitteln und Koinzidenzgatter zum digitalen Zusammensetzen der Quadraturkomponenten aufweist.

Die der Erfindung zugrundeliegende Aufgabe besteht darin, ein Demodulationsverfahren bzw. eine Demodulationsanordnung anzugeben, bei dem eine Miniaturisierung von für die drahtlose Signalübertragung verwendeten Geräten (z. B. Schnurlostelefonen) und Integrierbarkeit der dabei verwendeten Bauteile, speziell durch entsprechende Ausbildung der Demodulatoren, erreichbar ist.

Diese Aufgabe wird ausgehend von dem im Oberbegriff des Patentanspruches 1 definierten Verfahren durch die im kennzeichnenden Teil des Patentanspruches 1 angegebenen Merkmale gelöst.

Das erfindungsgemäße Demodulationsverfahren zeichnet sich dadurch aus, daß zu seiner Anwendung lediglich ein einziges analoges Bauelement, nämlich eines zur Durchführung der Differentiation oder der Integration (Anspruch 1) erforderlich ist. Alle anderen Bauelemente dienen der digitalen Signalverarbeitung und sind demgemäß in integrierter Schaltkreistechnik herstellbar und schaltungstechnisch einfach einzusetzen. Das erfindungsgemäße Verfahren verbindet somit ein digital aufbereitetes Signal im Niederfrequenzbereich mittels eines einzigen analogen Bauelementes mit einer digitalen Signalverarbeitung im Hochfrequenzbereich.

Vorteilhafte erfindungsgemäße Demodulationsanordnungen sind in den Ansprüchen 2 bis 5 angegeben.

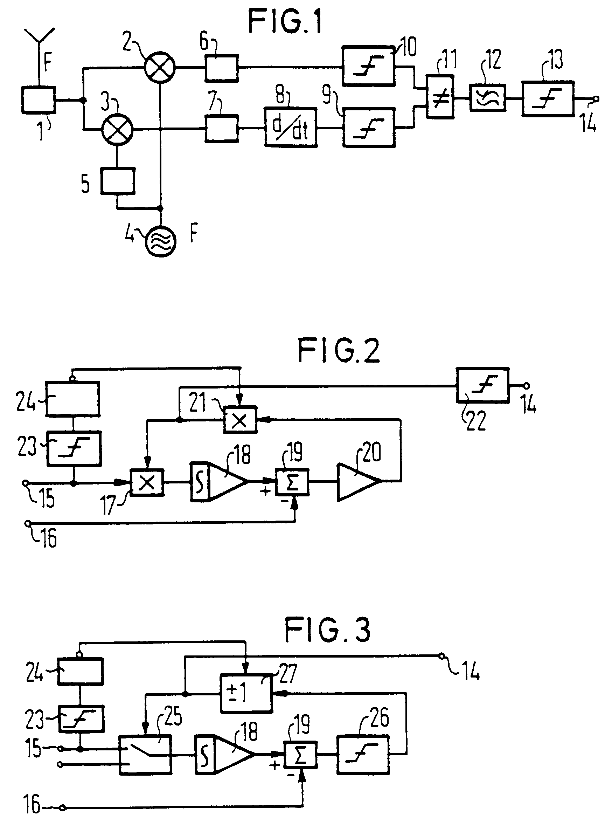

Ein erstes Ausführungsbeispiel der Erfindung wird anhand der Figur 1 beschrieben.

Figur 1 zeigt dabei den prinzipiellen Aufbau einer Schaltung zur Quadraturmodulation, bei der ein Demodulator mit Differentiation einer Quadraturkomponente vorgesehen ist.

Ein zweites und drittes Ausführungsbeispiel der Erfindung ist in den Figuren 2 und 3 dargestellt.

In den Figuren 2 und 3 sind Demodulatoren gezeigt, bei denen eine Integration einer Quadraturkomponente stattfindet.

Das zu demodulierende Signal ist in den drei genannten Ausführungsbeispielen ein Impulstelegramm, bei dem die Impulse durch eine um eine Basisfrequenz f erhöhte Mittenfrequenz F, also durch eine Frequenz (F+f) und die Impulspausen durch die um diese Basisfrequenz f verminderte Mittenfrequenz F, also durch eine Frequenz (F-f) repräsentiert werden. Die Mittenfrequenz F weist etwa 2 GHz auf, während sich die Basisfrequenz f in einer Frequenzlage von etwa 0,5 MHz befindet. Diese beiden Frequenzen (F+f) und (F-f) werden von einem auf die Mittenfrequenz F als Trägerfrequenz abgestimmten Empfänger 1 empfangen und zwei Modulatoren 2 und 3 zugeführt. Im Modulator 2 wird das empfangene Signal mit einer am Empfangsort von einem Oszillator 4 erzeugten Modulationsfrequenz gemischt, die etwa gleich mit der empfangenen Mittenfrequenz F ist. Während die Modulationsschwingung des Oszillators 4 dem Modulator 2 unmittelbar zugeführt wird, erhält der Modulator 3 eine Modulationsschwingung, die mittels eines Phasenschiebers 5 um eine Viertelperiode (90°) gegenüber der ursprünglichen Modulationsschwingung phasenverschoben ist. An den Ausgängen der Modulatoren 2, 3 bilden sich somit zwei quadraturmodulierte Signale von der Basisfrequenz f. Allfällige, von der Demodulation stammende hochfrequente Störungen werden durch Tiefpaßfilter 6, 7 ausgefiltert.

Das während der Dauer der Impulse empfangene Signal ist als Funktion der Zeit t folgendermaßen darstellbar:

$$\cos 2\pi (F+f)t = \cos 2\pi Ft \cdot \cos 2\pi ft -$$

$$- \sin 2\pi Ft \cdot \sin 2\pi ft.$$

Im Modulator 2 wird dieses Signal mit der Oszillatorschwingung $\cos 2\pi FT$ multiplikativ gemischt. Zufolge der Orthogonalität von Cosinus- und Sinus-Funktionen liefert der erste, auf der rechten Seite der Gleichung stehende Ausdruck nach der Modulation die Quadraturkomponente $\cos 2\pi ft$, während der zweite Ausdruck verschwindet. Im Mcdulator 3 wird hingegen durch die Modulation mit der Schwingung $\sin 2\pi Ft$ der erste Ausdruck zum Verschwinden gebracht und aus dem zweiten Ausdruck die Quadraturkomponente $- \sin 2\pi ft$ gewonnen.

Das während der Impulspausen empfangene Signal ist darstellbar durch:

$$\cos 2\pi (F\text{-}f)t = \cos 2\pi Ft \cdot \cos 2\pi ft +$$

$$+ \sin 2\pi Ft \cdot \sin 2\pi ft.$$

Im Modulator 2 wird auch in diesem Fall die Quadraturkomponente cos $2\pi$ ft gewonnen, wähend der Modulator 3 jedoch die Quadraturkomponente + sin $2\pi$ ft liefert. Die Ausgangssignale des Modulators 3 haben somit während der Dauer der Impulse einerseits und während der Dauer der Impulspausen anderseits entgegengesetzte Vorzeichen. Dieser Unterschied wird beim erfindungsgemäßen Verfahren als Kriterium zur Unterscheidung von Impulsen und Impulspausen herangezogen. Grundlage dieser Koinzidenzprüfung ist die Tatsache daß - abgesehen vom Vorzeichen und der Amplitude - der Differentialquotient und das Integral einer Sinus-Funktion eine Cosinus-Funktion ist und umgekehrt. Das Ziel des erfindungsgemäßen Demodulationsverfahrens liegt nun darin, diese Unterscheidung mit minimalem technischen Aufwand aus den beiden jeweils gewonnenen Quadraturkomponenten zu erhalten.

Im einzelnen erfolgt dies bei der Ausführung nach Figur 1 dadurch, daß aus der vom Modulator 3 gewonnenen Quadraturkomponente mittels eines analogen Differentiationsgliedes 8 deren Differentialquotient gebildet, der von einem nachgeschalteten Komparator 9 in ein digitales Signal umgewandelt wird, wenn ein gewisser Schwellwert des Komparator-Eingangssignales überschritten wird. Als Schwellwert dient der Mittelwert des Wertebereiches für die differenzierte Quadraturkomponente. Die vom Modulator 2 gelieferte und vom Tiefpaßfilter 6 gefilterte Quadraturkomponente wird einem zweiten Komparator 10 zugeführt, der seinerseits das Vorhandensein dieses Signals aufgrund der Überschreitung des Schwellwertes konstatiert. Da die Quadratursignale des Modulators 3 bei Impulsen und Impulspausen unterschiedliche Vorzeichen aufweisen, ergibt sich dieser Vorzeichenunterschied auch bei den Differentialquotienten dieser Signale.

Die Ausgänge der Komparatoren 9 und 10 sind an die Eingänge eines Koinzidenzgatters 11 (Antivalenzgatters) angeschlossen, das bei Vorzeichengleichheit des einen Quadratursignales und des Differentialquotienten des anderen Quadratursignales den Empfang eines Impulses und bei Vorzeichenungleichheit den Empfang einer Impulspause signalisiert. Das digitale Ausgangssignal des Koinzidenzgatters 11 entspricht im wesentlichen schon dem gewünschten Datensignal, es enthält jedoch noch kurze, durch Schaltvorgänge in den Komparatoren bedingte falsche logische Zustände, sowie Jitter. Die kurzfristig auftretenden falschen logischen Zustände können in einem, dem Antivalenzgatter 11 nachgeschalteten Tiefpaßfilter 12 und einem weiteren Komparator 13 eliminiert werden. Die Grenzfrequenz des Tiefpaßfilters 12 muß dabei größer als die Datenrate sein. Als Schaltschwelle des Komparators 13 wird der Mittelwert der Spannungen gewählt, die logisch 0 und logisch 1 repräsentieren. Am Ausgang 14 der Schaltung werden die demodulierten Rohdaten entnommen.

Figur 2 zeigt eine Variante einer Einrichtung zur Durchführung des erfindungsgemäßen Demodulationsverfahrens unter Verwendung eines analogen Integrators. Die beiden Quadraturkomponenten liegen an den Eingängen 15, 16 der Schaltung. Das eine Quadratursignal wird über einen Multiplizierer 17 einem Integrator 18 zugeführt. Vom Zeitintegral dieser, über den Eingang 15 zugeführten Quadraturkomponente wird in einem Summierglied 19 der Wert der anderen, über den Eingang 16 zugeführten Quadraturkomponente subtrahiert. Das Ausgangssignal des Summiergliedes 19 wird von einem Verstärker 20 verstärkt und über einen weiteren analogen Multiplizierer 21 an den zweiten Eingang des Multiplizierers 17 zurückgeführt, sowie an einen Komparator 22 geliefert, der das Ausgangssignal abgibt. Die Ansteuerung des analogen Multiplizierers 21 erfolgt von einem an den Eingang 15 angeschlossenen Komparator 23, dessen Ausgangssignal mittels eines Inverters 24 invertiert wird.

Bei der Demodulatorschaltung nach Figur 2 erfolgt die Gewinnung der Quadraturkomponenten aus dem Empfangssignal in identischer Weise wie in der Schaltungsvariante nach Figur 1, mit Hilfe einer Schaltung zur Quadraturmodulation, bestehend aus den Komponenten 1 bis 5, mit nachgeschalteten Tiefpaßfiltern 6 und 7. Die Ausgangssignale der Tiefpaßfilter 6 und 7 sind identisch mit den Eingangssignalen 15 und 16 der Demodulatorschaltung nach Figur 2.

Die Komponenten 17 bis 21 bilden einen Regelkreis, in welchem das Ausgangssignal des Verstärkers 20 das Regelsignal darstellt, welches mit Hilfe des Multiplizierers 17 die Amplitude des Quadratursignals 15 der Amlplitude des Quadratursignals 16 angleicht. Die zwischen den Quadratursignalen vorhandene Phasenverschiebung um den Winkel $\pi/2$ wird vom Integrierglied 18 kompensiert. Das Regelsignal wird im Summierglied 19 durch Subtraktion des Quadratursignals 16 vom integrierten und damit um $\pi/2$ phasenverschobenen Quadratursignal 15 gebildet und vom Regelsignalverstärker 20 verstärkt.

Bei positiver Schleifenverstärkung arbeitet der Regelkreis nur dann stabil, wenn die Signalspannung des Quadratursignals 15 ein negatives Vorzeichen aufweist. Durchläuft die Spannung des Quadratursignals 15 den Bereich positiver Vorzeichen, so wird das Vorzeichen der Schleifenverstärkung vom Multiplizierer 21 invertiert.

Ist das Vorzeichen der Spannung des Quadratursignals 15 positiv, so ist die Ausgangsspannung des Komparators 23 ebenfalls positiv und die Ausgangsspannung des nachfolgenden Inverters 24 negativ, andernfalls, für negative Vorzeichen der Spannung des Quadratursignals 15 ist die Ausgangsspannung des Komparators 23 negativ und die Ausgangsspannung des Inverters 24 entsprechend positiv. Durch die begrenzende Eigenschaft des Komparators 23 ist der Betrag der Ausgangsspannung des Inverters 24 nur vom Vorzeichen der Spannung des Quadratursignals 15 und nicht von dessen Betrag abhängig. Durch Multiplikation der Ausgangsspannung des Inverters 24 mit dem Regelsignal am Ausgang des Regelverstärkers 20 im Multiplizierer 21, erfolgt somit eine Umschaltung der Regelverstärkung derart, daß ein stabiler Betriebszustand der Regelschaltung 17 bis 21 sichergestellt ist.

Im stabilen Betrieb der Regelschaltung 17 bis 21 wird das Regelsignal am Ausgang des Regelverstärkers 20 so eingestellt, daß die Signale am Eingang 16 und am Ausgang des Integrators 18 eine möglichst geringe Abweichung voneinander aufweisen. Für den Fall, daß die Spannung des Quadratursignals 16 gleich der integrierten Spannung des Quadratursignals 15 ist, muß somit die Ausgangsspannung des Multiplizierers 21 ein positives, andernfalls ein negatives Vorzeichen aufweisen. Das Vorzeichen der Ausgangsspannung des Multiplizierers 21 entspricht dem Datenstrom des modulierten Empfangssignals. Damit kann aus dem Vorzeichen der Ausgangsspannung des Multiplizierers 21 mit Hilfe des Komparators 22 das demodulierte Impulstelegramm gewonnen werden.

Die Schaltungsvariante nach Figur 3 unterscheidet sich von der nach Figur 2 dadurch, daß kein analoger Rückkoppelpfad existiert. Die Bezifferungen sind weitgehend der Figur 2 entnommen. Die Funktion des im Eingangskreis der Schaltung nach Figur 2 liegenden Multiplizierers 17 übernimmt hier ein analoger Umschalter 25, der bei einem Steuersignal von logisch "1" das Quadratursignal vom Eingang 15, andernfalls das invertierte Quadratursignal an den Integrator 18 durchschaltet. Wie bei der Variante nach Figur 2 wird vom integrierten Quadratursignal das andere, vom Eingang 16 gelieferte Quadratursignal subtrahiert. Das Ausgangssignal des Summiergliedes 19 wird von einem nachgeschalteten Komparator 26 in ein digitales Signal umgewandelt. Das Ausgangssignal des Komparatos 26 wird über einen umschaltbaren Inverter 27 zur Umschaltung des Umschalters 25 herangezogen. Das Steuersignal für den Umschalter 25 ist gleich dem invertierten Datensignal, das dem Ausgang 28 entnommen wird. Die Ansteuerung des Inverters 17 erfolgt vom Komparator 23, dessen Ausgangssignal mittels des Inverters 24 logisch invertiert wird.

Die Demodulationsschaltung nach Figur 3 ist eine vereinfachte Version der Demodulationsschaltung nach Figur 2. Da für das Ergebnis des Demodulationsvorgangs lediglich das Vorzeichen des Regelsignals erforderlich ist, kann der Regelkreis durch einen digitalen Rückkoppelzweig geschlossen werden. Der Vorteil dieser Ausführungsform gegenüber jener nach Figur 2 besteht im wesentlich geringeren schaltungstechnischen Aufwand, da die komplizierten analogen Multiplizierer durch digitale Bauelemente ersetzt werden.

Wie in der Demodulationsschaltung nach Figur 2 bilden auch hier die Ausgangssignale der Tiefpaßfilter 6 und 7 nach Figur 1 die Quadratur-Eingangssignale 15 und 16. Im Unterschied zur Demodulationsschaltung nach Figur 2 muß hier das Quadratursignal 15 symmetrisch zur Verfügung stehen. Die Komponenten 18, 19 und 25 bis 27 bilden den Regelkreis, worin der Komparator 26 die Funktion des Regelverstärkers 20 und das Äquivalenzgatter 27 die Funktion des Multiplizierers 21 nach Figur 2 übernehmen. Die Multiplikation des Quadratursignals 15, mit dem Regelsignal am Ausgang des Äquivalenzgatters 27, erfolgt im Auswahlschalter 25, der damit den analogen Multiplizierer 17 nach Figur 2 ersetzt. Ist der logische Zustand des Regelsignals am Ausgang des Äquivalenzgatters 27 gleich 1, entsprechend einem positiven Vorzeichen der analogen Regelspannung nach Figur 2, so wird im Auswahlschalter 25 der positive Anteil des Quadratursignals 15 an den Integrator 18 weitergeleitet, andernfalls, für den logischen Zustand 0, entsprechend einem negativen Vorzeichen der analogen Regelspannung nach Figur 2, wird der negative Anteil des Quadratursignals 15 weitergeschaltet.

Das Regelsignal am Ausgang des Äquivalenzgatters 27 liegt bereits in digitaler Form vor und stellt das zu demodulierende Impulsdiagramm dar. Ein zusätzlicher Komparator, wie der Komparator 22 in Figur 2 ist daher nicht erforderlich.

**Patentansprüche**

1.  Verfahren zur Demodulation von in modulierte Signale umgesetzten Impulstelegrammen unter Verwendung einer Quadraturmodulation (2...7), wobei die als Analogsignale gewonnenen Quadraturkomponenten schwellwertbezogen analog/digital umgesetzt und anschließend mit einer Koinzidenz-Gatterlogik digital zusammengesetzt werden, **dadurch gekennzeichnet**, daß von den beiden, aus der Quadraturmodulation (2...7) als Analogsignale gewonnenen Quadraturkomponenten eine Quadraturkomponente vor der Analog/Digital-Umsetzung differenziert oder integriert wird und daß die analog/digital umgesetzten Quadraturkomponenten zum Impulstelegramm mit der Koinzidenz-Gatterlogik digital zusammengesetzt werden.

2.  Demodulationsanordnung zur Demodulation von in modulierte Signale umgesetzten Impulstelegrammen mit Quadraturmodulationsmitteln (2...7) zur Erzeugung von durch Quadraturmodulation als Analogsignale gewonnenen Quadraturkomponenten, Komparator-/Umsetzmitteln (9, 10) zur schwellwertbezogenen Analog/Digital-Umsetzung der Quadraturkomponenten und einem Koinzidenzgatter (11) zum digitalen Zusammensetzen der Quadraturkomponenten, **dadurch gekennzeichnet**, daß eine Differentiationseinrichtung(8) vorgesehen ist, die zwischen den Quadraturmodulationsmitteln (2...7) und den Komparator/Umsetzmitteln (9, 10) geschaltet ist.

3.  Demodulationsanordnung nach Anspruch 2, **dadurch gekennzeichnet**, daß das Koinzidenzgatter (11) zum digitalen Zusammensetzen der Quadraturkomponenten als Antivalenzgatter ausgebildet ist.

4.  Demodulationsanordnung zur Demodulation von in modulierte Signale umgesetzten Impulstelegrammen mit

    (a) Quadraturmodulationsmitteln (2...7) zur Erzeugung von durch Quadraturmodulation als Analogsignale gewonnenen Quadraturkomponenten,
    (b) einem ersten Multiplizierer (17) und einem Integrator (18), denen zum Bilden eines Zeitintegrals eine an einen ersten Eingang (15) anliegende Quadraturkomponente zugeführt wird,
    (c) einem Summierglied (19), das ein Regelsignal erzeugt, indem die an einem zweiten Eingang (16) anliegende andere Quadraturkomponente vom Zeitintegral subtrahiert wird,
    (d) einem zweiten Multiplizierer (21), der gesteuert durch eine mit dem ersten Eingang (15) verbundene Ansteuerschaltung (23, 24) das verstärkte Regelsignal an den ersten Multiplizierer (17) zurückführt und an einen Komparator (22) liefert, der aus dem Regelsignal das Impulstelegramm erzeugt,
    (e) einem die Merkmale (b)...(d) aufweisenden Regelkreis, der derart ausgebildet ist, daß die Quadraturkomponenten miteinander verglichen werden und die Stabilität des Regelkreises durch Umschaltung der Schleifenverstärkung erhalten wird.

5.  Demodulationsanordnung zur Demodulation von in modulierte Signale umgesetzten Impulstelegrammen mit

    (a) Quadraturmodulationsmitteln (2...7) zur Erzeugung von durch Quadraturmodulation als Analogsignale gewonnenen Quadraturkomponenten,
    (b) einem analogen Umschalter (25) und einem Integrator (18), denen zum Bilden eines Zeitintegrals eine an einen ersten Eingang (15) anliegende Quadraturkomponente zugeführt wird,
    (c) einem Summierglied (19), das ein Regelsignal erzeugt, indem die an einem zweiten Eingang (16) anliegende andere Quadraturkomponente vom Zeitintegral subtrahiert wird,
    (d) einer Analog/Digital-Schaltung (26, 27), die gesteuert durch eine mit dem ersten Eingang (15) verbundene Ansteuerschaltung (23, 24) aus dem Regelsignal das zum analog/digital umgewandelten Regelsignal invertierte Impulstelegramm erzeugt und dieses zur Umschaltung des Umschalters (25) an den analogen Umschalter (25) zurückführt,
    (e) einem die Merkmale (b)...(d) aufweisenden Regelkreis, der derart ausgebildet ist, daß die Quadraturkomponenten miteinander verglichen werden und die Stabilität des Regelkreises durch Umschaltung der Schleifenverstärkung erhalten wird.

## Claims

1.  Method for demodulating pulse messages, which have been converted into modulated signals, by using quadrature modulation (2...7), the quadrature components which have been obtained in the form of analog signals being converted from analog to digital with reference to a threshold value and subsequently assembled digitally by means of coincidence gate logic, characterized in that, of the two quadrature components which have been obtained from the quadrature modulation (2...7) in the form of analog signals, one quadrature component is differentiated or integrated prior to the analog-to-digital conversion, and in that the quadrature components converted from analog to digital are assembled digitally by means of coincidence gate logic to form the pulse message.

2.  Demodulation arrangement for demodulating pulse messages, which have been converted into modulated signals, with quadrature modulation means (2...7) for creating quadrature components which have been obtained in the form of analog signals by quadrature modulation, comparator/conversion means (9, 10) for analog-to-digital conversion, with reference to a threshold value, of the quadrature components and a coincidence gate (11) for digitally assembling the quadrature components, characterized in that a differentiation device (8) is provided which is connected between the quadrature modulation means (2...7) and the comparator/conversion means (9, 10).

3.  Demodulation arrangement according to Claim 2, characterized in that the coincidence gate (11) for digitally assembling the quadrature components is in the form of a non-equivalence gate.

4.  Demodulation arrangement for demodulating pulse messages, which have been converted into modulated signals, with

(a) quadrature modulation means (2...7) for generating quadrature components which have been obtained in the form of analog signals by quadrature modulation,

(b) a first multiplier (17) and an integrator (18), which are supplied, for the purpose of forming a time integral, a quadrature component present at a first input (15),

(c) a summing element (19) which produces a control signal by subtracting the other quadrature component present at a second input (16) from the time integral,

(d) a second multiplier (21) which, controlled by a drive circuit (23, 24) connected to the first input (15), feeds back the amplified control signal to the first multiplier (17) and supplies it to a comparator (22) which generates the pulse message from the control signal,

(e) a control circuit having the features (b) ... (d), which is configured in such a way that the quadrature components are compared with each other and the stability of the control circuit is maintained by switching over the loop amplification.

5. Demodulation arrangement for demodulating pulse messages, which have been converted into modulated signals, with

(a) quadrature modulation means (2...7) for generating quadrature components which have been obtained in the form of analog signals by quadrature modulation,

(b) an analog switch (25) and an integrator (18), which are supplied, for the purpose of forming a time integral, a quadrature component present at a first input (15),

(c) a summing element (19) which produces a control signal by subtracting the other quadrature component present at a second input (16) from the time integral,

(d) an analog-to-digital circuit (26, 27), which, controlled by a drive circuit (23, 24) connected to the first input (15), generates from the control signal the pulse message inverted with respect to the control signal which has been converted from analog to digital and feeds back this pulse message to the analog switch (25) for the purpose of switching the switch (25),

(e) a control circuit having the features (b)...(d), which is configured in such a way that the quadrature components are compared with each other and the stability of the control circuit is maintained by switching over the loop amplification.

**Revendications**

1. Procédé pour la démodulation de télégrammes d'impulsions convertis en signaux modulés, avec utilisation d'une modulation (2...7) en quadrature, les composantes de quadrature obtenues comme signaux analogiques étant converties par une conversion analogique/numérique en fonction d'une valeur seuil et ensuite recomposées numériquement par un circuit logique de coïncidence, caractérisé en ce que l'on différencie ou l'on intègre avant la conversion analogique/numérique une composante de quadrature parmi les deux composantes de quadrature obtenues comme signaux analogiques à partir de la modulation (2...7) en quadrature et en ce que l'on recompose numériquement, par le circuit logique de coïncidence, les composantes de quadrature converties par une conversion analogique/numérique en un télégramme d'impulsions.

2. Dispositif de démodulation pour la démodulation de télégrammes d'impulsions convertis en signaux modulés, comportant des moyens (2...7) de modulation en quadrature pour produire des composantes de quadrature obtenues comme signaux analogiques par modulation en quadrature, des moyens (9, 10) de comparaison/conversion pour convertir, par une conversion analogique/numérique, les composantes de quadrature en fonction d'une valeur seuil et un circuit (11) de coïncidence pour recomposer numériquement les composantes de quadrature, caractérisé en ce qu'il est prévu un dispositif (8) de différenciation qui est branché entre les moyens (2...7) de modulation en quadrature et les moyens (9, 10) de comparaison/conversion.

3. Dispositif de démodulation suivant la revendication 2. caractérisé en ce que le circuit (11) de coïncidence servant à recomposer numériquement les composantes de quadrature est réalisé en circuit d'anticoïncidence.

4. Dispositif de démodulation pour démoduler des télégrammes d'impulsions convertis en signaux modulés, comportant

(a) des moyens (2...7) de modulation en quadrature pour produire des composantes de quadrature obtenues comme signaux analogiques par modulation en quadrature,

(b) un premier multiplicateur (17) et un intégrateur (18) auxquels est envoyée, pour former une intégrale dans le temps, une composante de quadrature s'appliquant à une première entrée (15),

(c) un élément (19) de sommation qui produit un signal de régulation, dans lequel il est soustrait de l'intégrale dans le temps l'autre composante de quadrature s'appliquant à une deuxième entrée (16),

(d) un deuxième multiplicateur (21) qui, en étant commandé par un circuit (23, 24) de commande relié à la première entrée (15), renvoie le signal de régulation amplifié au premier multiplicateur (17) et le fournit à un comparateur (22) qui, à partir du signal de régulation, produit le télégramme d'impulsions,

(e) une boucle d'asservissement fermée qui comporte les dispositions (b)...(d) et qui est réalisée de telle manière que les composantes de quadrature sont comparées les unes aux autres et que la stabilité de la boucle d'asservissement fermée est maintenue par commutation de l'amplification en boucle.

5. Dispositif de démodulation pour démoduler des télégrammes d'impulsions convertis en signaux modulés, comportant

(a) des moyens (2...7) de modulation en quadrature pour produire des composantes de quadrature obtenues comme signaux analogiques par modulation en quadrature,

(b) un commutateur (25) analogique et un intégrateur (18) auxquels est envoyée, pour former une intégrale dans le temps, une composante de quadrature s'appliquant à une première entrée (15),

(c) un élément (19) de sommation qui produit un signal de régulation. dans lequel il est soustrait de l'intégrale dans le temps l'autre composante de quadrature s'appliquant à une deuxième entrée (16),

(d) un circuit (26, 27) analogique/numérique, qui, en étant commandé par un circuit (23, 24) de commande relié à la première entrée (15), produit à partir du signal de régulation le télégramme d'impulsions inversé par rapport au signal de régulation converti par une conversion analogique/numérique et le renvoie au commutateur (25) analogique pour commuter le commutateur (25),

(e) une boucle d'asservissement fermée qui comporte les dispositions (b)...(d) et qui est réalisée de telle manière que les composantes de quadrature sont comparées les unes aux autres et que la stabilité de la boucle d'asservissement fermée est maintenue par commutation de l'amplification en boucle.

# FIG.1

# FIG.2

# FIG.3